# EUROPEAN PATENT APPLICATION

(11) **EP 2 228 831 A2**
(43) Date of publication of application: **15.09.2010**
(21) Application number: 10250464.4
(22) Date of filing: 12.03.2010
(51) Int. Cl.: H01L 31/048, H01L 31/02

(54) **Solar cell module**

(30) Priority: 13.03.2009 JP 2009062111
(71) Applicant: Sanyo Electric Co., Ltd., Osaka 570-8677 (JP)
(72) Inventor: Aou, Masayuki, Moriguchi City Osaka 570-8677 (JP)
(74) Representative: Calderbank, Thomas Roger

(57) **Abstract**

A solar cell module comprises a solar cell having a light receiving surface and a rear surface provided on the opposite side of the light receiving surface; a light-receiving-surface-side protection member disposed on the light-receiving-surface-side of the solar cell; a rear-surface-side protection member disposed on the rear-surface-side of the solar cell and having a metal layer sandwiched between a plurality of resin layers; and a output lead configured to draw electric power from the solar cell, wherein the rear-surface-side protection member has an opening portion formed by folding back a first area in the rear-surface-side protection member, one end portion of the output lead is electrically connected to the solar cell, and the other end portion of the output lead is drawn out from the opening portion.

## Description

This application is based upon and claims the benefit of priority from prior Japanese Patent Application No. 2009-62111, filed on March 13, 2009; the entire contents of which are incorporated herein by reference.

The present invention relates to a solar cell module including an output lead configured to draw electric power from the solar cell.

A solar cell is expected as a new energy source because the solar cell directly converts clean and inexhaustibly supplied sunlight into electricity. Generally, in order to increase the weather resistance of a solar cell, the solar cell is sealed with a sealing member between a light-receiving-surface-side protection member and a rear-surface-side protection member.
Electric power generated by the solar cell is drawn to the outside of the solar cell module by an output lead connected to the solar cell. Specifically, the output lead is drawn out to the outside of the solar cell module through a linear slit formed in the rear-suxface-side protection member (for example, refer to Japanese Patent Application Publication No. Hei 5-82820).
As the rear-surface-side protection member, there is widely used a laminated film which is formed in a sheet shape by sandwiching a metal layer such as aluminum layer between resin layers (for example, refer to Japanese Patent Application Publication No. Hei 5-82820). The moisture resistance and gas barrier property of the solar cell module can be improved by using such rear-surface-side protection member.
When the above-mentioned laminated film is used as the rear-surface-side protection member, a metal layer is exposed to the inner side of the slit for the rear-surface-side protection member. Thus, in order to provide electrical insulation between the output lead and the metal layer, the output lead is generally covered with an insulating film.
However, since the insulating film and the metal layer are in direct contact with each other, the electrical insulation between the output lead and the metal layer needs to be improved if the solar cell module has a high output.
The invention is made in view of the above-mentioned circumstances, and it is an object of the invention to provide a solar cell module capable of securing electrical insulation between a metal layer of a rear-surface-side protection member and an output lead.

An aspect of the present invention is summarized as a solar cell module comprising: a solar cell having a light receiving surface and a rear surface provided on the opposite side of the light receiving surface; a light-receiving-surface-side protection member disposed on the light-receiving-surface-side of the solar cell; a rear-surface-side protection member disposed on the rear-surface-side of the solar cell and having a metal layer sandwiched between a plurality of resin layers; and an output lead configured to draw electric power from the solar cell, wherein the rear-surface-side protection member has an opening portion formed by folding back a first area in the rear-surface-side protection member, one end portion of the output lead is electrically connected to the solar cell, and the other end portion of the output lead is drawn out from the opening portion.
In the above aspect of the present invention, the first area may be folded back to an inside of the solar cell module.
In the above aspect of the present invention, one of the resin layers of the first area may be exposed to the opening portion.
In the above aspect of the present invention, the first area may be folded back to an outside of the solar cell module.
In the above aspect of the present invention, one of the resin layers of the first area may be exposed to the opening portion.
In the above aspect of the present invention, a second area in the rear-surface-side protection member may be folded back, and the opening portion may be located between the first area and the second area.
In the above aspect of the present invention, one of the first area and the second area may be folded back to an inside of the solar cell module, and the other may be folded back to an outside of the solar cell module.
In the above aspect of the present invention, further comprising a terminal box provided on the rear-surface-side protection member in such a manner as to cover the opening portion, wherein the first area is folded back to the outside of the solar cell module, and the first area is fixed to an inside of the terminal box.
In the above aspect of the present invention, the solar cell module may include an internal separation member located between the plurality of solar cells and the rear-surface-side protection member.

In the drawings
Fig. 1 is a side view of a solar cell module 100 according to a first embodiment of the invention.
Fig. 2 is a plan view from the rear-surface-side protection member 14 of the solar cell module 100 according to the first embodiment of the invention.
Fig. 3 is a cross-sectional view taken along the line A-A of Fig. 2.
Fig. 4 is a perspective view to illustrate a manufacturing method of the solar cell module 100 according to the first embodiment of the invention.
Fig. 5 is a plan view to illustrate a formation method of an opening portion 141 according to the first embodiment of the invention.
Fig. 6 is a plan view from the rear-surface-side protection member 14 of the solar cell module 100 according to a second embodiment of the invention.
Fig. 7 is a cross-sectional view taken along the line B-B of Fig. 6.
Fig. 8 is a plan view from the rear-surface-side protection member 14 of the solar cell module 100 according to a third embodiment of the invention.
Fig. 9 is a cross-sectional view taken along the line C-C of Fig. 8.
Fig. 10 is a plan view to illustrate a formation method of an opening portion 141 according to the third embodiment of the invention.
Fig. 11 is a plan view to illustrate another formation method of an opening portion 141 according to the third embodiment of the invention.

Next, embodiments of the invention are described with reference to the drawings. In the following description of the drawings, identical or similar reference numerals are given to identical or similar components. However, the drawings are only schematic, thus it should be noted that the ratios of dimensions are not shown to scale. Accordingly, specific dimensions should be recognized in consideration of the following description. Also, there are inevitably included some portions of the drawings between which a dimensional relationship and/or a scale are inconsistent.

### [First Embodiment]

### [Schematic Structure of Solar Cell Module]

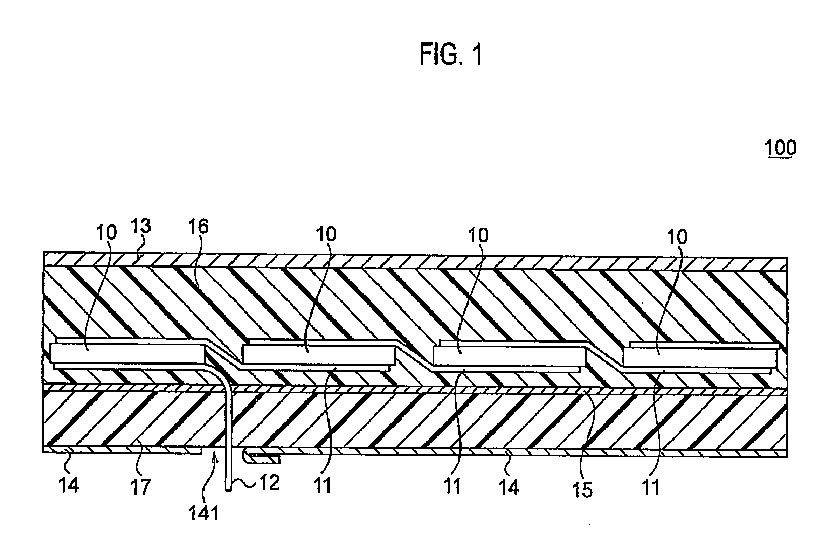

[0016] The schematic structure of a solar cell module 100 according to the first embodiment of the invention is described with reference to Fig. 1. Fig.1 is a side view of the solar cell module 100 according to the first embodiment of the invention.

As shown in Fig. 1, the solar cell module 100 includes a plurality of solar cells 10, a plurality of connecting members 11, an output lead 12, a light-receiving-surface-side protection member 13, a rear-surface-side protection member 14, an internal separation member 15, a first sealing member 16, and a second sealing member 17. The solar cell module 100 is configured by sealing the plurality of solar cells 10 between the light-receiving-surface-side protection member 13 and the rear-surface-side protection member 14.

The plurality of solar cells 10 are arranged in a matrix form between the light-receiving-surface-side protection member 13 and the rear-surface-side protection member 14. The plurality of solar cells 10 is electrically connected by the plurality of connecting members 11. Each of the solar cells 10 has a light receiving surface to receive light and a rear surface provided on the opposite side of the solar cell 10 from the light receiving surface. Although not shown, each solar cell 10 includes a photoelectric conversion body configured to generate a carrier by receiving light on the light receiving surface and a pair of positive and negative electrodes configured to draw the career from the photoelectric conversion body.

Each of the plurality of connecting members 11 is connected to the electrode formed on the light receiving surface of one solar cell 10, and the electrode formed on the rear surface of another solar cell 10 adjacent to the one solar cell 10. Thereby, the one solar cell 10 and the other solar cell 10 are electrically connected to each other. Each connecting member 11 is preferably composed of a thin plate or a twisted wire made of a low electrical resistance material such as copper, silver, gold, tin, nickel, aluminum, or an alloy of these metals. The surface of each connecting member 11 may be covered with a conductive material such as lead-free solder (e.g., SnAg_{3.0}Cu_{0.5} solder).

The output lead 12 is a wiring member configured to draw the electric power generated by the plurality of solar cells 10 to the outside thereof. The output lead 12 is covered with an insulating film. One end portion of the output lead 12 is electrically connected to an electrode of at least one solar cell 10. The other end portion of the output lead 12 is drawn out from an opening portion 141 formed in the rear-surface-side protection member 14, and is connected to a connection terminal in a terminal box which is not shown. Specifically, the other end portion of the output lead 12 is exposed to the outside of the solar cell module 100 from the second sealing member 17 exposed to the opening portion 141. Although not shown, the solar cell module 100 is generally provided with a pair of positive and negative output leads. Similarly to the connecting members 11, the output lead 12 is preferably composed of a low electrical resistance material.

The light-receiving-surface-side protection member 13 is disposed on the light-receiving-surface-side of the plurality of solar cells 10. The light-receivingsurface-side protection member 13 protects the surface of the solar cell module 100. As the light-receiving-surface-side protection member 13, a glass which is translucent and impervious to water or translucent plastic can be used.

The rear-surface-side protection member 14 is disposed on the rear-surface-side of the plurality of solar cells 10. The rear-surface-side protection member 14 protects the rear surface of the solar cell module 100. The rear-surface-side protection member 14 according to the first embodiment has a structure in which a metal layer is sandwiched between two resin layers. The rear-surface-side protection member 14 has an opening portion 141 through which the other end portion of the output lead 12 is drawn out to the outside of the solar cell module. The configuration of the rear-surface-side protection member 14 is described below.

The internal separation member 15 is located between the plurality of solar cells and the rear-surface-side protection member. The internal separation member 15 separates the inside of the solar cell module 100 into two parts. The internal separation member 15 has a function to prevent water from penetrating into the plurality of solar cells 10 from the rear-surface-side protection member 14. The output lead 12 is inserted through the internal separation member 15. As the internal separation member 15, a material such as a PET film can be used.

The first sealing member 16 seals the plurality of solar cells 10 between the light-receiving-surface-side protection member 13 and the internal separation member 15. The second sealing member 17 is filled into between the rear-surface-side protection member 14 and the internal separation member 15. As the first sealing member 16 and the second sealing member 17, translucent resin such as EVA, EEA, PVB, silicon, urethane, acryl, and epoxy can be used. The first sealing member 16 and the second sealing member 17 may be composed of the same material, or different materials with each other.

An aluminum frame may be mounted on the outer circumference of the solar cell module 100 which has the above configuration.

### [Configuration of Rear-Surface-Side Protection Member]

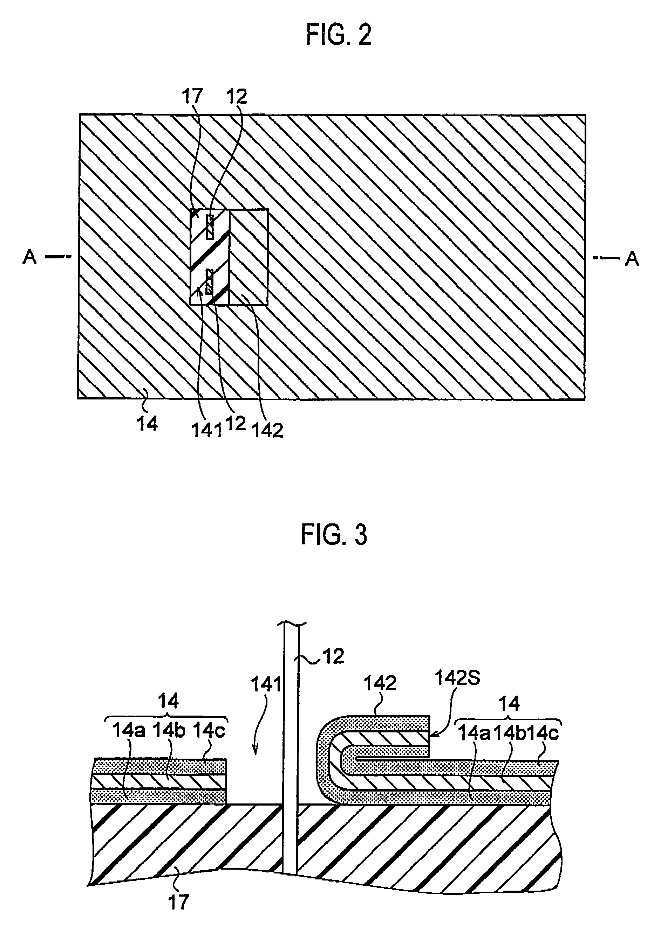

Next, the configuration of the rear-surface-side protection member 14 is described with reference to Figs. 2 and 3. Fig. 2 is a plan view from the rear-surface-side protection member 14 of the solar cell module 100 according to the first embodiment of the invention. Fig. 3 is a cross-sectional view taken along the line A-A of Fig. 2.

As shown in Fig. 2, the rear-surface-side protection member 14 has the opening portion 141 and a first area 142. The second sealing member 17 is exposed to the opening portion 141. The output lead 12 is drawn out from the second sealing member 17 exposed to the opening portion 141. In the first embodiment, the first area 142 is folded back to an outside of the solar cell module 100. The opening portion 141 is formed by folding back the first area 142 outward from the solar cell module 100. The formation method of the opening portion 141 is described below.

As shown in Fig. 3, the rear-surface-side protection member 14 is configured by a first resin layer 14a, a metal layer 14b, and a second resin layer 14c. The metal layer 14b is sandwiched between the first resin layer 14a and the second resin layer 14c. The first resin layer 14a and the second resin layer 14c are sheet-like resin films such as a PET film, for example. The metal layer 14b is an aluminum foil, for example. The metal layer 14b is exposed to an end face 142S of the first area 142.

The exposed end face 142S of the first area 142 is folded back away from the output lead 12. In this manner, the end face 142S of the first area 142 is arranged to be spaced away from the output lead 12. That is, the first area 142 is arranged so that the metal layer 14b exposed to the end face 142S is spaced away from the output lead 12. The first resin layer 14a which is one of resin layers of the first area 142 is exposed to the opening portion 141.

The first area 142 is folded back to be in contact with the surface of the rear-surface-side protection member 14, but the invention is not limited to this case. For example, the first area 142 may be arranged above the surface of the rear-surface-side protection member 14.

### [Manufacturing Method of Solar Cell Module]

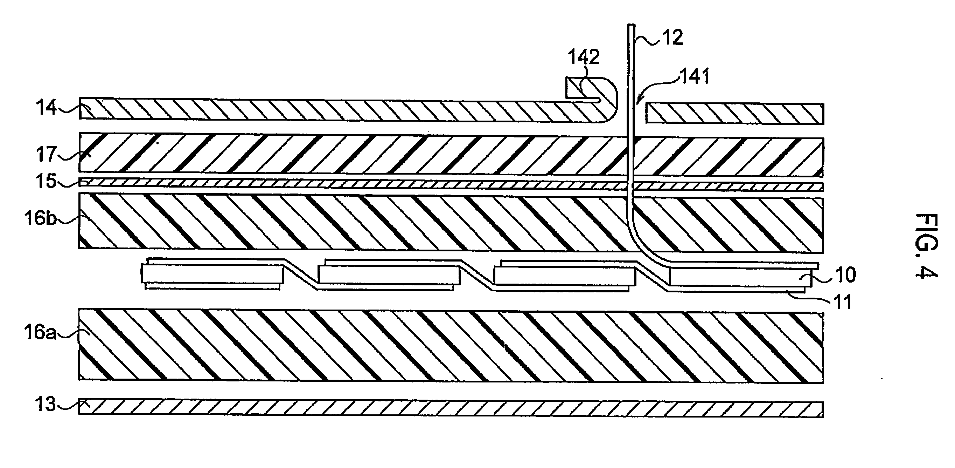

Next, a manufacturing method of the solar cell module 100 is described with reference to the drawings. Fig. 4 is an exploded sectional view of the solar cell module 100 before it is modularized.

First, the plurality of solar cells 10 arranged in a matrix form is electrically connected with the connecting member 11.

Next, one end portion of the output lead 12 is electrically connected to at least one solar cell 10.

Next, a slit is formed through the first sealing member 16b, the internal separation member 15, and the second sealing member 17 in the thickness direction for the output lead 12 to be inserted through the slit.

Next, the opening portion 141 is formed in the rear-surface-side protection member 14.

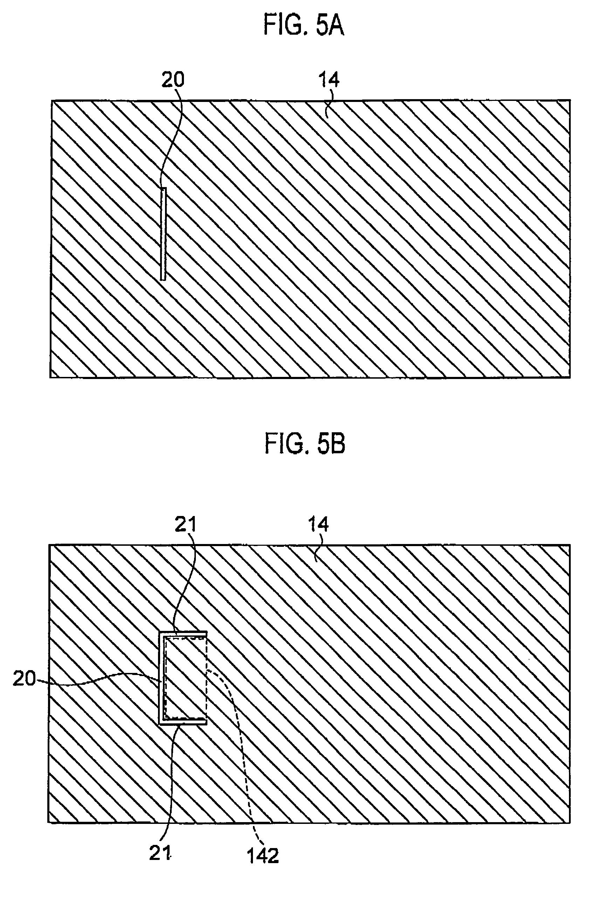

Specifically, at first, a linear slit 20 is formed in the rear-surface-side protection member 14 as shown in Fig. 5A. The slit 20 passes through the first resin layer 14a, the metal layer 14b, and the second resin layer 14c.

Next, as shown in Fig. 5B, a pair of slits 21 extending from both ends of the slit 20 is formed. The slits 21 pass through the first resin layer 14a, the metal layer 14b, and the second resin layer 14c. Consequently, the first area 142 is provided on one side of the slit 20.

Next, as shown in Fig. 4, the first area 142 is folded back to the rear-surface-side of the rear-surface-side protection member 14. Thereby, there is formed the opening portion 141 to draw out the output lead 12.

Next, a laminated body is formed by sequentially laminating the light-receiving-surface-side protection member 13, the first sealing member 16a, the plurality of solar cells 10, the first sealing member 16b, the internal separation member 15, the second sealing member 17, and the rear-surface-side protection member 14. In this step, as shown in Fig. 4, the other end portion of the wiring member 12 is drawn out through respective slits of the first sealing member 16b, the internal separation member 15, and the second sealing member 17, and through the opening portion 141 of the rear-surface-side protection member 14.

Next, the laminated body is heated in a predetermined condition in a vacuum atmosphere. Thereby, the first sealing member 16 and the second sealing member are cured.

### [Operation and Effect]

In the solar cell module 100 according to the first embodiment, the other end portion of the output lead 12 is drawn out from the opening portion 141. The opening portion 141 is formed by folding back the first area 142 provided on one side of the slit 20.

Accordingly, the output lead 12 can be spaced away from the end face 142S of the first area 142. Thus, it is possible to secure electrical insulation between the metal layer 14b exposed to the end face 142S of the first area 142 and the output lead 12. As a result, deterioration in performance of the solar cell module can be suppressed.

In the first embodiment, one side of the opening portion 141 is formed by folding back the first area 142, however, the invention is not limited to this case. For example, the plurality of first areas 142 may be provided while the respective plurality of first areas 142 are folded back to form the plurality of sides of the opening portion 141. In this case, electrical insulation between the metal layer 14b and the output lead 12 can be further secured.

### [Second Embodiment]

Next, the second embodiment of the invention is described with reference to the drawings. In the following, points of difference from the first embodiment mentioned above are mainly described. The first area 142 according to the second embodiment is folded back to the inside of the solar cell module 100.

### [Configuration of Rear-Surface-Side Protection Member]

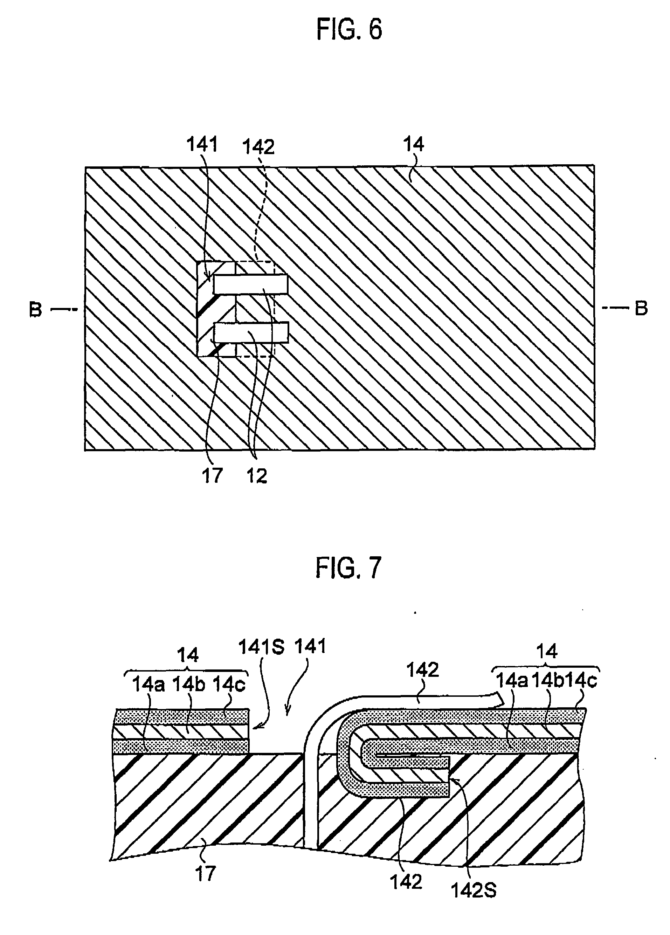

The configuration of the rear-surface-side protection member 14 according to the second embodiment is described with reference to Figs. 6 and 7. Fig. 6 is a plan view from the rear-surface-side protection member 14 of the solar cell module 100 according to the second embodiment of the invention. Fig. 7 is a cross-sectional view taken along the line B-B of Fig. 6.

As shown in Figs. 6 and 7, the first area 142 is folded back to the inside of the solar cell module 100. Therefore, the end face 142S of the first area 142 is sealed in the second sealing member 17. The output lead 12 is drawn out to the opposite side from the metal layer 14b exposed to an inner wall 141S of the opening portion 141. The first resin layer 14a which is one of resin layers of the first area 142 is exposed to the opening portion 141.

As described in the first embodiment above, such opening portion 141 is formed by folding back the first area 142 provided on one side of the slit 20 to the light-receiving-surface-side of the rear-surface-side protection member 14.

In the second embodiment, the output lead 12 is arranged to be in contact with the surface of the rear-surface-side protection member 14, but the invention is not limited to this case. The output lead 12 may be arranged to be spaced away from the surface of the rear-surface-side protection member 14.

### [Operation and Effect]

The first area 142 according to the second embodiment is folded back to the inside of the solar cell module 100. The output lead 12 is drawn out from the opening portion 141 to the first area 142 side.

The output lead 12 can be spaced away from the end face 142S of the first area 142. Also, the output lead 12 can be spaced away from the inner wall 141S of the opening portion 141. Thus, it is possible to secure electrical insulation between the output lead 12 and the metal layer 14b which is exposed to both of the end face 142S and the inner wall 141S.

In the first embodiment, one side of the opening portion 141 is formed by folding back the first area 142, however, the invention is not limited to this case. For example, the plurality of first areas 142 may be provided while the respective the plurality of first areas 142 are folded back to form the plurality of sides of the opening portion 141. In this case, electrical insulation between the metal layer 14b and the output lead 12 can be further secured.

### [Third Embodiment]

Next, a third embodiment of the invention is described with reference to the drawings. In the following, points of difference from the first embodiment mentioned above are mainly described. An opening portion 141 according to the third embodiment is formed by folding back the first area to the inside while folding back the second area to the outside.

### [Configuration of Rear-Surface-Side Protection Member]

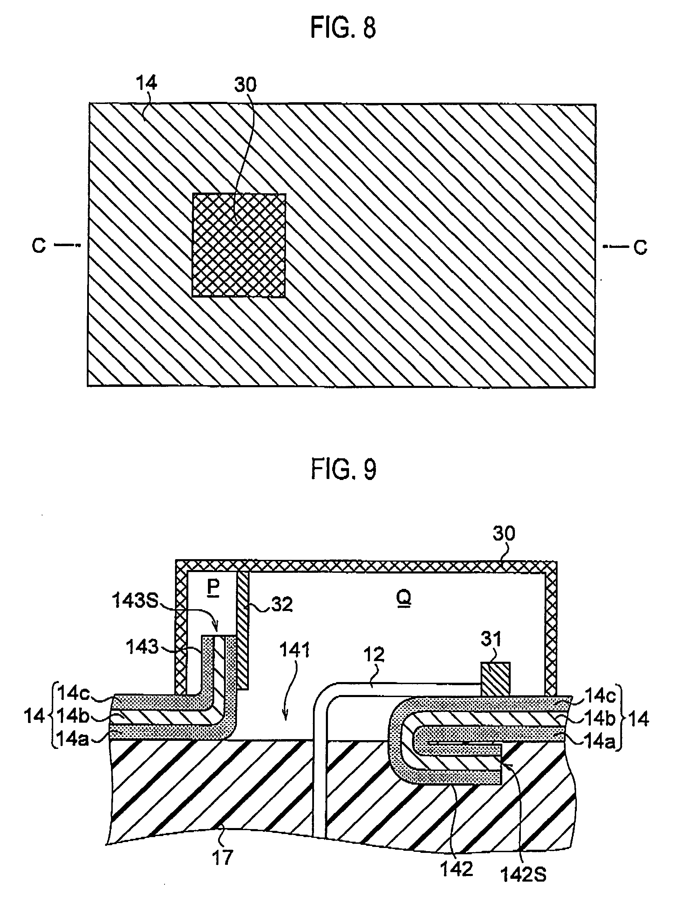

The configuration of the rear-surface-side protection member 14 according to the third embodiment is described with reference to Figs. 8 and 9. Fig. 8 is a plan view from the rear-surface-side protection member 14 of the solar cell module 100 according to the third embodiment of the invention. Fig. 9 is a cross-sectional view taken along the line C-C of Fig. 8.

As shown in Fig. 8, the solar cell module 100 according to the third embodiment is provided with a terminal box 30 mounted on the rear-surface-side protection member 14. The terminal box 30 is provided to cover the opening portion 141. Although not shown, silicone resin is used to seal the space between the terminal box 30 and the rear-surface-side protection member 14.

As shown in Figs. 9, the first area 142 is folded back to the inside of the solar cell module 100. Also, the second area 143 is folded back to the outside of the solar cell module 100. Thereby, the opening portion 141 is formed. The opening portion 141 is located between the first area 142 and the second area 143.

The terminal box 30 has a terminal connecting portion 31 and a partition portion 32. The terminal connecting portion 31 is connected to the end of the output lead 12. The partition portion 32 divides the inside of the terminal box 30 into a space P and a space Q. The space P is a space to fix the second area 143. Accordingly, an end face 143S of the second area 143 is exposed in the space P. The space Q is a space to draw out the output lead 12.

### [Formation Method of Opening Portion]

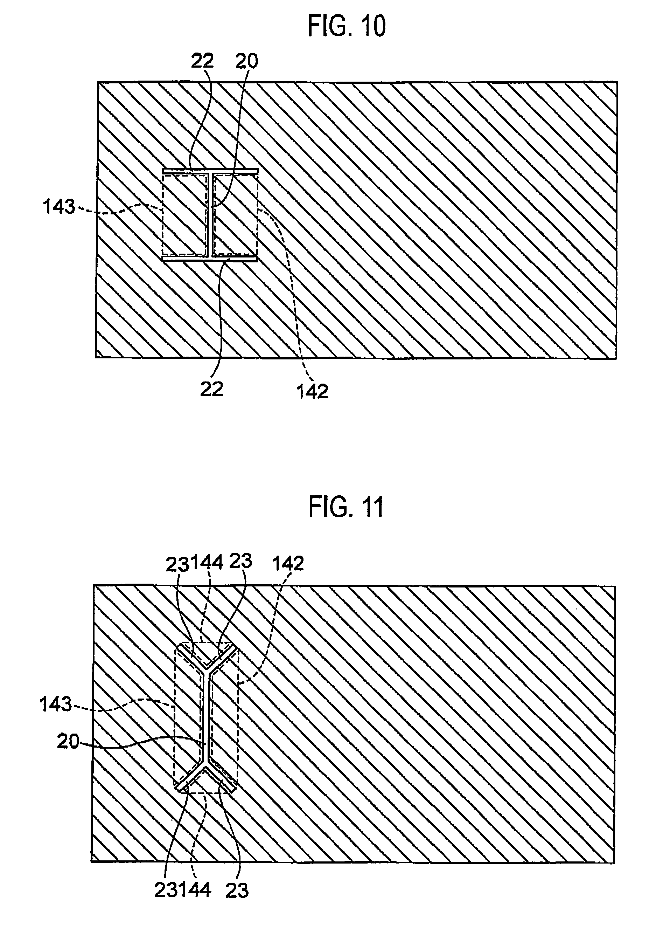

First, similarly to the first embodiment described above, a slit 20 is formed, and then by forming a pair of slits 22 orthogonal to the slit 20 at both ends of the slit 20, an H-shaped slit is formed in the rear-surface-side protection member 14 as shown in Fig. 10. Thereby, the first area 142 is provided on one side of the slit 20, while the second area 143 is provided on the other side of the slit 20.

Next, the first area 142 is folded back to the light-receiving-surface-side of the rear-surface-side protection member 14, while the second area 143 is folded back to the rear-surface-side of the rear-surface-side protection member 14. Thereby, there is formed the opening portion 141 to draw out the output lead 12.

### [Operation and Effect]

The first area 142 according to the third embodiment is folded back to the inside of the solar cell module 100, and the second area 143 is folded back to the outside of the solar cell module 100. Accordingly, the output lead 12 can be spaced away from both of the end face 142S of the first area 142 and the end face 143S of the second area 143. Thus, electrical insulation between the metal layer 14b and the output lead 12 can be further secured.

Also, in the terminal box 30, the second area 143 folded back to the outside of the solar cell module 100 is fixed. Accordingly, a short circuit between the metal layer 14b exposed to the end face 142S of the second area 143 and the output lead 12 can be prevented.

### [Other Embodiments]

Although the invention has been described according to the embodiments described above, it should be understood that the discussion and drawings which form part of the disclosure are not intended to limit the invention. Various alternative embodiments, implementation examples, and application techniques will be apparent to those skilled in the art.

For example, in the above embodiment, one example has been used to describe the configuration of the solar cell module, however, the invention is not limited to this example. For example, the solar cell module 100 may not be provided with the internal separation member 15. Also, the solar cell module 100 may be provided with thin-film solar cells laminated on the light-receiving-surface-side protection member 13 in replace of crystalline solar cells 10 described above.

Although the following has not been mentioned in the above embodiments, a wiring member for bypass diode connection may be drawn out along with the output lead 12 from the opening portion 141.

In the embodiments described above, the slit 20 is linearly formed, but the invention is not limited to this case. For example, the slit 20 may be formed in a curved shape. In this case, the first area 142 can be formed without further forming slits at both ends of the slit 20.

Also, in the embodiments described above, a rectangular or an H-shaped slit is formed in the rear-surface-side protection member 14, but the invention is not limited to this case. For example, as shown in Fig. 11, two slits 23 may be formed outward from respective both ends of the slit 20. In this case, an exposure of the metal layer 14b to the inner wall 141S of the opening portion 141 can be prevented by folding back a pair of areas 144 formed outwardly at both ends of the slit 20. Thus, electrical insulation between the output lead 12 and the metal layer 14b can be further secured.

In the above embodiment, the surface side protection member 14 has a configuration in which the metal layer is sandwiched between two resin layers, but the invention is not limited to this configuration. For example, the rear-surface-side protection member 14 may have three or more resin layers and may have two or more metal layers.

In the above embodiment, the first area 142 according to the third embodiment is folded back to the inside of the solar cell module 100, and the second area 143 is folded back to the outside of the solar cell module 100, but the invention is not limited to this configuration. For example, the first area 142 according to the third embodiment is folded back to the outside of the solar cell module 100, and the second area 143 is folded back to the inside of the solar cell module 100. In other words, one of the first area 142 and the second area 143 is folded back to an inside of the solar cell module 100, and the other is folded back to an outside of the solar cell module 100.

Thus, it should be understood that the invention includes various embodiments not specifically described herein. Accordingly, the technical scope of the invention should be defined only by the specifications of the invention according to the claims based on the above description.

## Claims

1. A solar cell module comprising:
a solar cell having a light receiving surface and a rear surface provided on the opposite side of the light receiving surface;
a light-receiving-surface-side protection member disposed on the light-receiving-surface-side of the solar cell;
a rear-surface-side protection member disposed on the rear-surface-side of the solar cell and having a metal layer sandwiched between a plurality of resin layers; and
an output lead configured to draw electric power from the solar cell, wherein
the rear-surface-side protection member has an opening portion formed by folding back a first area in the rear-surface-side protection member,
one end portion of the output lead is electrically connected to the solar cell, and
the other end portion of the output lead is drawn out from the opening portion.

2. The solar cell module according to claim 1, wherein
the first area is folded back to an inside of the solar cell module.

3. The solar cell module according to claim 2, wherein
one of the resin layers of the first area is exposed to the opening portion.

4. The solar cell module according to claim 1, wherein
the first area is folded back to an outside of the solar cell module.

5. The solar cell module according to claim 4, wherein
one of the resin layers of the first area is exposed to the opening portion.

6. The solar cell module according to claim 1, wherein
a second area in the rear-surface-side protection member is folded back, and
the opening portion is located between the first area and the second area.

7. The solar cell module according to claim 6, wherein
one of the first area and the second area is folded back to an inside of the solar cell module, and
the other is folded back to an outside of the solar cell module.

8. The solar cell module according to claim 1, further comprising a terminal box provided on the rear-surface-side protection member in such a manner as to cover the opening portion, wherein
the first area is folded back to the outside of the solar cell module, and
the first area is fixed to an inside of the terminal box.

9. The solar cell module according to claim 1, wherein
the solar cell module includes an internal separation member located between the plurality of solar cells and the rear-surface-side protection member.
